# FASCICULE DE BREVET EUROPEEN

(11) **EP 1 960 836 B1**
(45) Date de publication et mention de la délivrance du brevet: **16.10.2013**
(21) Numéro de dépôt: 06830336.1
(22) Date de dépôt: 04.12.2006
(51) Int. Cl.: G03F 1/24, G03F 1/56, B82Y 40/00, B82Y 10/00

(54) **PROCEDE DE FABRICATION DE MASQUE LITHOGRAPHIQUE EN REFLEXION ET MASQUE ISSU DU PROCEDE**
VERFAHREN ZUR HERSTELLUNG EINER REFLEKTIERENDEN LITHOGRAPHISCHEN MASKE, SOWIE EINE NACH DIESEM VERFAHREN HERGESTELLTE MASKE
METHOD FOR MAKING A REFLECTION LITHOGRAPHIC MASK AND MASK OBTAINED BY SAID METHOD

(30) Priorité: 13.12.2005 FR 0512611
(43) Date de publication de la demande: 27.08.2008
(73) Titulaire: Commissariat à l'Énergie Atomique et aux Énergies Alternatives, 75015 Paris (FR)
(72) Inventeur: CHARPIN-NICOLLE, Christelle, F-38120 Fontanil-cornillon (FR)
(74) Mandataire: Guérin, Michel
(86) Numéro de dépôt international: PCT/EP2006/069272
(87) Numéro de publication internationale: WO 2007/068617

(56) Documents cités:
- US-A- 4 332 879
- US-B1- 6 171 757
- US-B1- 6 436 605
- SEITZ H ET AL: "Recent results on EUV mask blank multilayers and absorbers" PROCEEDINGS OF THE SPIE - THE INTERNATIONAL SOCIETY FOR OPTICAL ENGINEERING SPIE-INT. SOC. OPT. ENG USA, vol. 5751, no. 1, mars 2005 (2005-03), pages 209-218, XP002397456 ISSN: 0277-786X
- DAVIDSON M R ET AL: "Novel route for the production of X-ray masks from a range of organometallic films" MICROELECTRONIC ENGINEERING, ELSEVIER PUBLISHERS BV., AMSTERDAM, NL, vol. 41-42, mars 1998 (1998-03), pages 279-282, XP004111680 ISSN: 0167-9317
- BING LU ET AL: "EUV radiation damage test on EUVL mask absorber materials" PROCEEDINGS OF THE SPIE - THE INTERNATIONAL SOCIETY FOR OPTICAL ENGINEERING SPIE-INT. SOC. OPT. ENG USA, vol. 5256, no. 1, 2003, pages 1232-1238, XP002397457 ISSN: 0277-786X

## Description

L'invention concerne la photolithographie, et notamment la photolithographie aux très courtes longueurs d'onde. Elle concerne plus précisément une structure de masque de lithographie destinée à être utilisée en réflexion, et un procédé de fabrication de cette structure de masque.

La photolithographie est utilisée pour la réalisation de microstructures électroniques, optiques, mécaniques ou des microstructures combinant des fonctions électroniques et/ou optiques et/ou mécaniques. Elle consiste à insoler par un rayonnement photonique, à travers un masque qui définit le motif souhaité, une couche de résine photosensible déposée sur un substrat plan (par exemple une tranche de silicium). Le développement chimique qui suit l'insolation révèle les motifs souhaités dans la résine. Le motif de résine ainsi gravé peut servir à plusieurs usages, le plus commun étant la gravure d'une couche sous-jacente (isolante ou conductrice ou semi-conductrice) pour y définir un motif identique à celui de la résine.

On cherche à obtenir des motifs extrêmement petits et précis et à aligner très précisément des motifs gravés dans de multiples couches superposées. Typiquement, la dimension critique des motifs souhaités est aujourd'hui d'une fraction de micromètre, voire même un dixième de micromètre et au-dessous.

Des tentatives ont été faites pour utiliser des procédés lithographiques n'utilisant pas la lumière mais des bombardements électroniques ou ioniques ; ces procédés sont plus complexes que les procédés de lithographie utilisant des photons à diverses longueurs d'onde (visible, ultraviolet, X). Si on s'en tient à la photolithographie optique, c'est la réduction de la longueur d'onde qui permet de réduire la dimension critique des motifs. La photolithographie en ultraviolet (longueurs d'onde descendant jusqu'à 193 nanomètres) est devenue courante.

On cherche aujourd'hui à descendre très largement au-dessous de ces longueurs d'onde et à travailler en extrême ultraviolet (EUV), à des longueurs d'onde comprises entre 10 et 14 nanomètres et qui sont en pratique des longueurs d'onde de rayons X mous. Le but est d'obtenir une très haute résolution, tout en gardant une ouverture numérique faible et une profondeur de champ suffisante (supérieure à 1 micromètre).

A de telles longueurs d'onde, une particularité du procédé de photolithographie est que le masque d'exposition de la résine fonctionne en réflexion et non en transmission : la lumière en extrême ultraviolet est projetée par une source sur le masque ; le masque comporte des zones absorbantes et des zones réfléchissantes ; dans les zones réfléchissantes, le masque réfléchit la lumière sur la résine à exposer, en y imprimant son image. Le trajet de la lumière entre le masque et la résine à exposer passe par d'autres réflecteurs dont les géométries sont conçues pour projeter une image réduite du masque et non une image en grandeur réelle. La réduction d'image permet de graver sur la résine exposée des motifs plus petits que ceux qui sont gravés sur le masque.

Le masque lui-même est fabriqué à partir d'une photogravure d'une résine, cette fois en transmission, comme on l'expliquera plus loin, et avec une longueur d'onde plus grande, autorisée par le fait que les motifs sont plus grands.

Typiquement, un masque en réflexion est composé d'un substrat plan recouvert d'une structure réfléchissante continue, en pratique un miroir de Bragg, recouverte d'une couche absorbante gravée selon le motif de masquage désiré.

Le miroir doit être aussi réfléchissant que possible à la longueur d'onde de travail prévue pour l'utilisation du masque. La couche absorbante doit être aussi absorbante que possible à cette longueur d'onde ; elle doit pouvoir être déposée sans détérioration de la structure réfléchissante, ce qui implique notamment un dépôt à température pas trop élevée (inférieure à 150°C) ; elle doit aussi pouvoir être gravée sans détérioration de la structure réfléchissante et on prévoit en général une couche tampon entre la couche absorbante et le miroir. La hauteur de l'empilement de la couche tampon et la couche absorbante doit être aussi faible que possible afin de minimiser les effets d'ombrage lorsque l'incidence du rayonnement n'est pas parfaitement normale à la surface du masque.

Les procédés de fabrication connus de masques par réflexion en EUV sont coûteux du fait du nombre important des étapes nécessaires à la fabrication, et ils aboutissent souvent à des empilements absorbants de hauteur importante, donc à des effets d'ombrage, notamment du fait que les contraintes de température empêchent d'utiliser des matériaux suffisamment absorbants.

Pour pallier les inconvénients des procédés connus, l'invention propose un procédé de fabrication d'un masque de photolithographie en extrême ultraviolet, fonctionnant en réflexion, dans lequel on dépose, sur un substrat revêtu d'une structure réfléchissante pour la longueur d'onde d'utilisation du masque, une couche contenant un métal ayant un fort coefficient d'absorption pour cette longueur d'onde, et on grave cette couche absorbante selon un motif désiré, pour définir un motif de zones qui sont absorbantes à la longueur d'onde d'utilisation du masque, caractérisé en ce que la couche déposée est une couche de composé organométallique sensible à un bombardement et contenant ce métal, et en ce que les zones absorbantes sont constituées par ce composé organométallique polymérisé après insolation sélective de la couche dans ces zones.

Par l'expression "couche sensible à un bombardement", on entend une couche sensible soit à des photons (en ultraviolet, long ou court, voire même des rayons X mous) soit à des particules (électrons ou ions). La couche se polymérise sous l'effet de ce bombardement. Dans la suite, pour simplifier, on utilisera l'appellation "couche photosensible" aussi bien pour désigner une couche sensible à un bombardement photonique qu'une couche sensible à un bombardement électronique ou ionique, et on utilisera l'appellation "insolation" pour désigner une exposition à des photons aussi bien qu'une exposition à des électrons ou des ions.

Ainsi, c'est la couche photosensible elle-même qui, après polymérisation par l'insolation sélective, constitue les zones absorbantes du masque, le masque étant réfléchissant en dehors de ces zones grâce à la structure réfléchissante formée sur le substrat.

Sous l'effet de l'insolation sélective, la couche se transforme en un polymère organométallique ; le métal absorbant constitue un élément des chaînes polymériques. Le choix du métal est dicté par ses propriétés d'absorption à la longueur d'onde d'extrême ultraviolet à laquelle on veut utiliser le masque.

Il n'est pas nécessaire de déposer sous la couche absorbante une couche tampon protégeant la structure réfléchissante contre la gravure plasma de la couche absorbante comme c'était le cas dans la technique antérieure. En effet, le motif de zones absorbantes est obtenu par un simple développement chimique de la résine photosensible, et ce développement chimique n'est pas agressif pour la structure réfléchissante.

Par conséquent, il n'est pas nécessaire de procéder à la succession d'étapes suivantes : dépôt de couche tampon, dépôt de couche absorbante, dépôt de résine photosensible, insolation de la résine, développement de la résine, gravure de la couche absorbante, enlèvement dé la résine, et gravure de la couche tampon. Toutes ces étapes sont remplacées par : dépôt de résine, insolation de la résine, développement de la résine. Cette réduction de nombre d'étapes réduit le coût de fabrication et est d'autant plus favorable que les étapes de gravure de la couche absorbante et de la couche tampon étaient particulièrement délicates dans l'art antérieur.

De plus, certains métaux absorbants qu'on ne pouvait pas utiliser dans l'art antérieur peuvent maintenant être utilisés. En effet, dans l'art antérieur il fallait se limiter à des métaux déposables à faible température (inférieure à 150°C), sous peine de détériorer la structure réfléchissante. Pour certains métaux, déposés par pulvérisation, la température de dépôt est nécessairement supérieure à cette valeur, ce qui empêchait de les utiliser. En incorporant ces métaux à un composé organique, on peut les déposer à faible température.

Les métaux préférés selon l'invention sont le platine, le palladium, l'yttrium, l'hafnium, le zirconium, le fer, mais aussi l'aluminium, le titane, ou encore plusieurs de ces métaux. Tous ces métaux ont de bonnes propriétés d'absorption dans l'extrême ultraviolet et peuvent s'associer à certains monomères photosensibles pour s'incorporer aux chaînes de polymères lors de la polymérisation.

L'insolation sélective qui produit la polymérisation a lieu de préférence en ultraviolet, mais une exposition sélective à un faisceau d'électrons ou d'ions (pour aboutir au même résultat : polymère organométallique) peut aussi être envisagée.

De préférence, le composé organométallique est choisi parmi les acrylates organométalliques, les méthacrylates organométalliques, les styrènes organométalliques, et leurs mélanges. Le polymère résultant de l'insolation est un homopolymère ou un copolymère de ces monomères.

Outre le procédé de fabrication dont les grandes lignes viennent d'être indiquées, l'invention porte également sur un masque de photolithographie en extrême ultraviolet, fonctionnant en réflexion, comportant un substrat, une structure réfléchissante déposée uniformément sur le substrat, et une couche absorbante pour la longueur d'onde d'utilisation du masque, déposée au-dessus de la structure réfléchissante et gravée selon un motif de masquage désiré, ce masque étant caractérisé en ce que la couche absorbante est un polymère organométallique contenant un métal à forte absorption pour la longueur d'onde d'utilisation du masque.

L'invention est applicable principalement aux masques dits "binaires" dans lesquels le motif est défini simplement par l'absorption forte des rayons extrême-ultraviolets dans les zones comportant la couche absorbante et la réflexion forte dans les zones qui ne comportent pas la couche absorbante. Mais l'invention est applicable aussi aux masques dits à décalage de phase atténués (ou "attenuated phase shift masks" en anglais) dans lesquels le motif est défini non seulement par cette différence d'absorption mais aussi par l'augmentation de contraste due à la différence de phase entre les rayons réfléchis dans les zones absorbantes et les rayons réfléchis dans les zonés non absorbantes voisines.

On notera que des composés organométalliques ont déjà été utilisés pour constituer des résines photosensibles particulièrement résistantes à la gravure plasma, de sorte qu'elles peuvent être utilisées pour la gravure de couches sous-jacentes nécessitant des composés d'attaque plasma très agressifs. Mais ces résines n'ont pas été utilisées comme couches absorbantes pour la réalisation de masques en réflexion dans lesquels la résine elle-même forme des îlots absorbants là où le masque ne doit pas être réfléchissant. Le brevet US 6 171 757 donne des exemples de ces résines.

L'invention sera mieux comprise par la description d'un procédé de fabrication des masques fonctionnant en EUV selon l'invention en référence aux figures indexées dans lesquelles :
- la figure 1 représente un masque de l'état de l'art, fonctionnant par réflexion, de type binaire ;
- les figures 2a à 2d montrent les étapes principales de fabrication selon l'invention, d'un masque fonctionnant par réflexion.

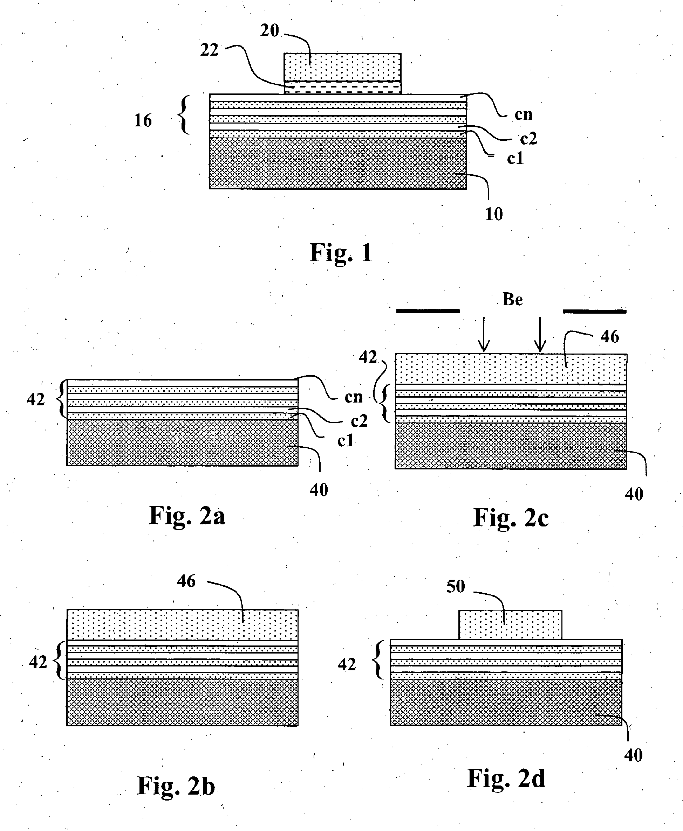

La figure 1 représente un masque de photolithographie "binaire" de l'art antérieur, fonctionnant en réflexion en extrême ultraviolet. Il est composé d'un substrat plan 10 recouvert d'une structure réfléchissante continue. La structure réfléchissante est une superposition .de couches c1, c2, ...cn, transparentes à la longueur d'onde extrême ultraviolet à laquelle le masque sera utilisé en réflexion. Les couches sont des couches alternées d'indice optique différents et leurs épaisseurs sont choisies en fonction des indices et de la longueur d'onde d'utilisation pour constituer un miroir de Bragg de fort coefficient de réflexion à cette longueur d'onde.

Le miroir de Bragg ainsi constitué est revêtu d'une couche absorbante 20 pour cette longueur d'onde et cette couche est gravée selon le motif de masquage désiré. Ce motif est géométriquement dans un rapport plus grand que 1 (typiquement un rapport 4) avec le motif que le masque projettera en cours d'utilisation sur une couche à graver.

Une couche tampon 22 est en principe prévue entre la couche absorbante et la structure réfléchissante. Elle participe éventuellement à l'absorption mais elle sert surtout de couche d'arrêt de gravure pendant la photogravure de la couche absorbante.

Dans l'art antérieur, les matériaux utilisés comme couche absorbante sont typiquement des métaux tels que le titane, le tantale, le tungstène, le chrome, ou l'aluminium, et également des composés de ces métaux tels que le siliciure de tantale, le nitrure de titane, le titane-tungstène, L'épaisseur de l'empilement de la couche tampon et la couche absorbante est relativement élevée dès lors qu'on veut obtenir une absorption suffisante (réflexion inférieure à 0,5%). Par exemple, il faut typiquement 70 nm de chrome sur 90 nm de couche tampon de silice ;

Cette hauteur globale est importante et aboutit à des effets d'ombrage non négligeables : des rayons arrivant en oblique sous une incidence (même faible) sont masqués sur une distance latérale qui détériore la résolution lors de l'utilisation du masque. Pour une incidence donnée, la distance latérale d'ombrage est d'autant plus grande que la hauteur de l'empilement est plus grande.

L'invention permet, entre autres, de réduire la hauteur de l'empilement. Les figures 2a à 2d montrent les étapes de fabrication d'un exemple de procédé de fabrication, selon l'invention, d'un masque fonctionnant par réflexion dans l'extrême ultraviolet.

Les principales étapes sont les suivantes :
- dépôt sur un substrat plan 40 d'une structure réfléchissante pour la longueur d'onde d'utilisation du masque en extrême ultraviolet ; la structure est un empilement 42 d'une alternance de couches transparentes c1, c2,...cn d'indices différents et d'épaisseurs choisies en fonction des indices pour constituer une structure réfléchissante de type miroir de Bragg (figure 2a) ; à titre d'exemple, le dépôt des couches est fait par pulvérisation par faisceau d'ions ou « Ion Beam Sputtering » en langue anglaise : on pulvérise sur le substrat plusieurs dizaines de paires de couches transparentes, par exemple 40 paires, chaque paire comportant par exemple une couche en molybdène et une couche en silicium ; l'épaisseur totale de chaque paire est d'environ 6,9 nanomètres pour une réflexion optimale à une longueur d'onde d'environ 13,8 nanomètres ; le coefficient de réflexion dépasse alors 60% et peut atteindre même 75% ; les paires de couches peuvent aussi être des paires molybdène/béryllium ou ruthénium/béryllium ; le substrat peut être une tranche de silicium ou une plaque de verre ou de quartz de 200 mm de diamètre ;
- dépôt (figure 2b), sur la structure réfléchissante 42, d'une couche uniforme 46 d'un monomère organométallique comportant un métal ayant de bonnes propriétés d'absorption à la longueur d'onde extrême ultraviolet d'utilisation du masque (typiquement entre 10 nm et 14 nm) ; les métaux utilisés dans le monomère sont choisis parmi les suivants : Pt, Pd, Al, Ti, Y, Hf, Zr, Fe ou plusieurs de ces métaux ; la proportion de métal dans la couche est de 10 à 90% ;
- insolation de la couche 46, par exemple, par bombardement d'électrons Be (figure 2c) ou par bombardement ionique, ou par photons ultraviolets selon le type de monomère utilisé ; les ultraviolets sont en principe des ultraviolets longs (190 à 350 nanomètres) mais ils peuvent être aussi des ultraviolets courts, voire de l'extrême ultraviolet ;
- développement chimique de la couche 46, polymérisée là où elle a été exposée, non polymérisée ailleurs, éliminant les zones non polymérisées et conservant des zones polymérisées 50 constituant les zones absorbantes du masque en réflexion. Les parties éliminées par le développement laissent à nu la surface réfléchissante de la structure de miroir 42. La figure 2d représente le masque en réflexion terminé, qui réfléchira les ultraviolets extrêmes aux longueurs d'onde de fonctionnement du miroir de Bragg, sauf là où il y a des zones absorbantes 50.

Les monomères utilisés dans le procédé de fabrication sont choisis notamment parmi les acrylates, méthacrylates, styrènes organométalliques ou des mélanges de ces monomères. Des exemples de monomères sont le 2-Mcenylethyl acrylate ou le 2-Mcenylmethyl acrylate ou le 2-(Mcenylmethyl-2-uréthano)-ethyl methacrylate ou le 4-Mcenylmethylstyrene où M désigne le métal choisi parmi les métaux indiqués plus haut. Un mode de préparation de ces composés peut être trouvée dans le brevet US 6 171 757.

Le développement de la couche photosensible après exposition peut s'effectuer en utilisant un solvant des monomères non insolés, par exemple de l'éthyl-3-ethoxypropionate.

Grâce à l'invention, on peut maintenant utiliser comme métal absorbant des métaux tels que le platine qu'on ne savait pas utiliser auparavant car ils nécessitaient une température de dépôt trop élevée, non compatible avec la conservation de la qualité de la structure réfléchissante multicouche. Maintenant, l'utilisation de ces métaux se fait par dépôt du monomère à basse température, ce qui évite toute détérioration.

Certains de ces matériaux, typiquement le platine, l'yttrium, le hafnium, le zirconium, ont d'excellentes propriétés d'absorption des extrêmes ultraviolets de 10 à 14 nm, et il suffit alors d'une faible épaisseur de couche absorbante pour obtenir une absorption suffisante. L'épaisseur peut être de l'ordre de 40 nanomètres, ce qui réduit les effets d'ombrage en incidence oblique.

L'invention conduit à une diminution des coûts de fabrication du masque du fait du nombre d'étapes technologiques inférieures à celles nécessaires pour la fabrication des masques de l'état de l'art ; en outre ce procédé permet :
- d'éviter le dépôt du matériau pour la couche tampon puisqu'on s'affranchit de l'étape de gravure de la couche absorbante telle qu'elle est réalisée dans l'état de l'art ;
- d'éviter des étapes difficiles à contrôler, en particulier les étapes de gravure de l'empilement absorbant ;
- d'utiliser des matériaux à hautes performances d'absorption dans l'extrême UV et que l'on ne pourrait pas utiliser dans les procédés de l'état de l'art.

L'invention a été décrite en détail à propos d'un masque binaire mais peut aussi être utilisée pour la réalisation d'un masque à décalage de phase atténué dans lequel la couche absorbante joue non seulement un rôle d'absorbant mais aussi un rôle de déphaseur de la fraction de lumière qu'elle réfléchit.

## Revendications

1. Procédé de fabrication d'un masque de photolithographie en extrême ultraviolet, fonctionnant en réflexion, dans lequel on dépose, sur un substrat (40) revêtu d'une structure (42) réfléchissante pour la longueur d'onde d'utilisation du masque, une couche (46) contenant un métal ayant un fort coefficient d'absorption pour cette longueur d'onde; et on grave cette couche absorbante selon un motif désiré, pour définir un motif de zones (50) qui sont absorbantes à la longueur d'onde d'utilisation du masque, **caractérisé en ce que** la couche déposée est une couche de composé organométallique sensible à un bombardement et contenant le métal ayant un fort coefficient d'absorption, et **en ce que** les zones absorbantes sont constituées par ce composé organométallique polymérisé après insolation sélective de la couche dans ces zones.

2. Procédé selon la revendication 1, **caractérisé en ce que** l'insolation sélective est effectuée par un bombardement photonique, électronique ou ionique.

3. Procédé selon la revendication 1, **caractérisé en ce que** le métal est choisi parmi les métaux suivants : le platine, le palladium, l'yttrium, l'hafnium, le zirconium, le fer, l'aluminium, le titane, ou encore des mélanges de ces différents métaux.

4. Procédé selon l'une des revendications 1 à 3, **caractérisé en ce que** le composé organométallique est choisi parmi les acrylates organométalliques, les méthacrylates organométalliques, les styrènes organométalliques, et leurs mélanges.

5. Procédé selon l'une des revendications 1 à 4, **caractérisé en ce que** le métal est en proportion de 10 à 90% dans la couche.

6. Masque de photolithographie en extrême ultraviolet, fonctionnant en réflexion, comportant un substrat (40), une structure réfléchissante (42) déposée uniformément sur le substrat, et une couche (50) absorbante, pour la longueur d'onde d'utilisation du masque, déposée au-dessus de la structure réfléchissante et gravée selon un motif de masquage désiré, ce masque étant **caractérisé en ce que** la couche absorbante est un polymère organométallique contenant un métal à forte absorption pour la longueur d'onde d'utilisation du masque.

7. Masque de photolithographie selon la revendication 6, **caractérisé en ce que** le métal est choisi parmi les métaux suivants : platine, palladium, aluminium, titane, yttrium, hafnium, zirconium, fer ou plusieurs de ces métaux.

8. Masque de photolithographie selon la revendication 7, **caractérisé en ce que** la résine organométallique comporte du métal dans une proportion de métal de 10 à 90% de la couche.

## Patentansprüche

1. Verfahren zur Herstellung einer fotolitographischen Maske im extremen Ultraviolett, die reflektierend arbeitet, wobei auf ein Substrat (40), das mit einer für die Benutzungswellenlänge der Maske reflektierenden Struktur (42) beschichtet ist, eine Schicht (46) aufgebracht wird, die ein Metall enthält, das einen hohen Absorptionskoeffizienten für diese Wellenlänge hat, und die absorbierende Schicht gemäß einem gewünschten Motiv graviert wird, um ein Motiv von Zonen (50) zu bestimmen, die in der Benutzungswellenlänge der Maske absorbierend sind, **dadurch gekennzeichnet, dass** die aufgebrachte Schicht eine Schicht einer organometallischen Verbindung ist, die auf einen Beschuss empfindlich reagiert und das Metall enthält, das einen hohen Absorptionskoeffizienten hat, und dass die absorbierenden Zonen von dieser polymerisierten organometallischen Verbindung nach selektiver Sonnenbestrahlung der Schicht in diesen Zonen gebildet werden.

2. Verfahren nach Anspruch 1, **dadurch gekennzeichnet, dass** die selektive Sonnenbestrahlung durch einen Photonen-, Elektronen- oder Ionenbeschuss durchgeführt wird.

3. Verfahren nach Anspruch 1, **dadurch gekennzeichnet, dass** das Metall aus den folgenden Metallen ausgewählt ist: Platin, Palladium, Yttrium, Hafnium, Zirkonium, Eisen, Aluminium, Titan, oder auch aus den Gemischen dieser verschiedenen Metalle.

4. Verfahren nach einem der Ansprüche 1 bis 3, **dadurch gekennzeichnet, dass** die organometallische Verbindung aus den organometallischen Acrylaten, den organometallischen Methacrylaten, den organometallischen Styrolen und ihren Gemischen ausgewählt ist.

5. Verfahren nach einem der Ansprüche 1 bis 4, **dadurch gekennzeichnet, dass** das Metall in Anteilen von 10 bis 90 % in der Schicht ist.

6. Fotolitographische Maske im extremen Ultraviolett, die reflektierend arbeitet, die ein Substrat (40), eine gleichmäßig auf das Substrat aufgebrachte reflektierende Struktur (42) und eine für die Benutzungswellenlänge der Maske absorbierende Schicht (50), die auf der reflektierenden und gemäß einem gewünschten Maskenmotiv gravierten Struktur aufgebracht ist, aufweist, wobei diese Maske **dadurch gekennzeichnet ist, dass** die absorbierende Schicht ein organometallisches Polymer ist, das ein Metall mit hoher Absorption für die Benutzungswellenlänge der Maske enthält.

7. Fotolitographische Maske nach Anspruch 6, **dadurch gekennzeichnet, dass** das Metall aus den folgenden Metallen ausgewählt ist: Platin, Palladium, Aluminium, Titan, Yttrium, Hafnium, Zirkonium, Eisen oder aus mehreren dieser Metalle.

8. Fotolitographische Maske nach Anspruch 7, **dadurch gekennzeichnet, dass** das organometallische Harz Metall in einem Metallanteil von 10 bis 90 % in der Schicht aufweist.

## Claims

1. A process for fabricating an extreme ultraviolet photolithography mask operating in reflection, in which there is deposited, on a substrate (40) coated with a reflecting structure (42), which is reflective at the operating wavelength of the mask, a layer (46) containing a metal having a high absorption coefficient for this wavelength, and this absorbent layer is etched in a desired pattern so as to define a pattern of zones (50) that are absorbent at the operating wavelength of the mask, **characterized in that** the deposited layer is a layer of an organometallic compound sensitive to bombardment and containing the metal having a high absorption coefficient, and **in that** the absorbent zones are formed by this organometallic compound polymerized after selective irradiation of the layer in these zones.

2. The process as claimed in claim 1, **characterized in that** the selective irradiation is carried out by photon, electron or ion bombardment.

3. The process as claimed in claim 1, **characterized in that** the metal is chosen from the following metals: platinum, palladium, yttrium, hafnium, zirconium and iron, aluminum, titanium, or else mixtures of these various metals.

4. The process as claimed in one of claims 1 to 3, **characterized in that** the organometallic compound is chosen from organometallic acrylates, organometallic methacrylates, organometallic styrenes and mixtures thereof.

5. The process as claimed in one of claims 1 to 4, **characterized in that** the metal is in a proportion of 10 to 90% in the layer.

6. An extreme ultraviolet photolithography mask operating in reflection, comprising a substrate (40), a reflecting structure (42) uniformly deposited on the substrate, and an absorbent layer (50), which is absorbent at the operating wavelength of the mask, said layer being deposited on top of the reflecting structure and etched in a desired masking pattern, this mask being **characterized in that** the absorbent layer is an organometallic polymer containing a metal having a high absorption for the operating wavelength of the mask.

7. The photolithography mask as claimed in claim 6, **characterized in that** the metal is chosen from the following metals: platinum, palladium, aluminum, titanium, yttrium, hafnium, zirconium, iron or several of these metals.

8. The photolithography mask as claimed in claim 7, **characterized in that** the organometallic resist contains metal with a proportion of metal of 10 to 90% in the layer.
